# EUROPÄISCHE PATENTSCHRIFT

(11) **EP 2 329 699 B1**
(45) Veröffentlichungstag und Bekanntmachung des Hinweises auf die Patenterteilung: **28.11.2012**
(21) Anmeldenummer: 09775640.7
(22) Anmeldetag: 22.09.2009
(51) Int. Cl.: H05K 3/26, H05K 3/02, C11D 3/00, C11D 7/06, C11D 7/08, C11D 7/26, C11D 7/32, C11D 7/34, C11D 11/00

(54) **VERFAHREN ZUM VERBESSERN DER KORROSIONSBESTÄNDIGKEIT EINER ELEKTRONISCHEN KOMPONENTE, INSBESONDERE VON LEITERBAHNEN EINER LEITERPLATTE**
METHOD FOR IMPROVING THE CORROSION RESISTANCE OF AN ELECTRONIC COMPONENT, PARTICULARLY OF CONDUCTORS OF A PRINTED CIRCUIT BOARD
PROCÉDÉ POUR AMÉLIORER LA RÉSISTANCE À LA CORROSION D UN COMPOSANT ÉLECTRONIQUE, EN PARTICULIER DE TRACÉS CONDUCTEURS D UN CIRCUIT IMPRIMÉ

(30) Priorität: 24.09.2008 AT 5242008 U
(43) Veröffentlichungstag der Anmeldung: 08.06.2011
(73) Patentinhaber: AT & S Austria Technologie & Systemtechnik Aktiengesellschaft, 8700 Leoben-Hinterberg (AT)
(72) Erfinder: VORABERGER, Hannes, A-8045 Graz (AT)
(74) Vertreter: Miksovsky, Alexander
(86) Internationale Anmeldenummer: PCT/AT2009/000367
(87) Internationale Veröffentlichungsnummer: WO 2010/034047

(56) Entgegenhaltungen:
- EP-A2- 1 584 708
- DE-A1- 2 610 032
- US-A- 5 814 588
- US-A1- 2008 182 025
- US-B1- 6 277 799

## Beschreibung

Die vorliegende Erfindung bezieht sich auf ein Verfahren zum Verbessern der Korrosionsbeständigkeit einer elektronischen Komponente, insbesondere von Leiterbahnen einer Leiterplatte, wobei nach einem Ausbilden von aus Kupfer gebildeten Leiterbahnen diese einer Vorbehandlung unterworfen werden, in welcher an der Oberfläche der Leiterbahnen befindliche Ionen oder lonenverunreinigungen durch eine Reinigungsbehandlung entfernt werden.

Weitere Bearbeitungen nach einem Ausbilden von Leiterbahnen im Zusammenhang mit der Herstellung einer Leiterplatte können beispielsweise die Aufbringung und Härtung einer Lötmaske zur Vorbereitung und Aufbringung von weiteren Schichten bzw. Elementen oder zur Strukturierung einer Leiterplattenlage oder die Anordnung bzw. Ausbildung weiterer bzw. zusätzlicher Leiterplaftenlagen beinhalten. Insbesondere bei weiter zunehmender Verringerung der Abmessungen derartiger Leiterplattenlagen, insbesondere der Dicke derselben, als auch gegebenenfalls weiterer Verringerung der Abmessungen und des gegenseitigen Abstands von Leiterbahnen können die nachfolgend genannten Probleme auch zwischen Leiterbahnen einzelner, übereinander angeordneter Leiterplattenlagen insbesondere bei einem Einsatz unter feuchten und erhöhte Temperaturen aufweisenden Bedingungen auftreten.

Verfahren der eingangs genannten Art sind beispielsweise der US 6 277 799 B1 oder der US 5 814 588 A zu entnehmen, wobei eine Reinigung durch Einsatz von wäßrigen Alkali-Reinigungslösungen insbesondere bei elektronischen Schaltungen oder leitfähigen Mustern durchgeführt werden soll. Darüber hinaus ist der EP 1 584 708 A2 ein Verfahren zur Behandlung von laser strukturierten Kunststoffoberflächen zu entnehmen, welche nachfolgend zu metallisieren sind.

Im Zusammenhang mit der Herstellung von Leiterplatten und vor dem Einsatz derartiger Leiterplatten ist es bekannt, Leiterplatten einer Vielzahl von Tests zu unterziehen, wobei insbesondere Leiterplatten, welche unter feuchten und gegebenenfalls gegenüber Umgebungstemperatur erhöhte Temperatur aufweisenden Bedingungen eingesetzt werden solfen, einem sogenannten HAST (High Accelerated Stress Test) unterworfen werden. In einem derartigen Test müssen zu überprüfende Leiterplatten beispielsweise einen Widerstand von mehr als 10 MOhm für wenigstens 264 Stunden bei einer Umgebungstemperatur von 110 °C und einer relativen Feuchtigkeit von 85 % bei einem gegenüber Umgebungsdruck geringfügig erhöhten Druck von beispielsweise 1,2 bar aufrecht erhalten. Bei derartigen Testbedingungen und allgemein bei einem Einsatz unter Bedingungen hoher Feuchtigkeit und erhöhter Temperatur hat sich gezeigt, daß eine Vielzahl von mit üblichen Herstellungsverfahren hergestellten Leiterplatten, insbesondere nach einem Ausbilden von aus Kupfer gebildeten Leiterbahnen, welche durch den zunehmend komplexen Aufbau von Leiterplatten beispielsweise eine geringe Dicke und somit insbesondere einen entsprechend verringerten gegenseitigen Abstand voneinander von weniger als 50 Mikrometer aufweisen, und beispielsweise einer nachträglichen Aufbringung einer Lötmaske oder einer Aufbringung einer weiteren Leiterplattenlage für ein in weiterer Folge vorzunehmendes Kontaktieren von Teilbereichen der Leiterplatte Korrosionseinflossen unterworfen sind. Dadurch versagen derartige Leiterplatten in weiterer Folge insbesondere bei einem Einsatz in Umgebung erhöhter Feuchtigkeit und gegebenenfalls zusätzlich erhöhter Temperatur, wie sie beispielsweise in dem oben genannten Test zum Einsatz gelangen und welche eine Überprüfung für einen Langzeiteinsatz unter derartigen Bedingungen erhöhter Feuchtigkeit und gegebenenfalls erhöhter Temperatur simulieren sollen.

Ein derartiges Versagen unter Ausbildung von Kurzschlüssen oder dgl. vor Ablauf der oben angegebenen Mindestzeitdauer in dem Test oder bei Einsatz von derartigen Leiterplatten unter derartigen widrigen Bedingungen läßt sich insbesondere auf ein Ausbilden von Kupferdendriten und somit einer auf Elektronen basierenden Leitfähigkeit oder eine Ausbildung von Kupferfilamenten und somit eine auf Ionen basierenden Leitfähigkeit zwischen den insbesondere einen geringen gegenseitigen Abstand voneinander aufweisenden Leiterbahnen zurückführen. Für diese bekannten Phänomene bzw. Mechanismen, die seit längerem bekannt und beschrieben sind, fehlen jedoch Lösungsvorschläge zur Vermeidung dieser Phänomene bzw. Mechanismen, welche bei zunehmend geringerem Abstand und gegebenenfalls geringerer Dicke von Leiter bahnen zu einem großen Anteil von derartige Überprüfungen bzw. Tests nicht bestehenden und somit auszuscheidenden Produkten führen.

Die vorliegende Erfindung zielt daher darauf ab, ein Verfahren der eingangs genannten Art zur Verfügung zu stellen, womit es gelingt, die Korrosionsbeständigkeit einer elektronischen Komponente, insbesondere von Leiterbahnen einer Leiterplatte dahingehend zu verbessern, daß die Einsatzmöglichkeiten derartiger Leiterplatten insbesondere in Umgebungen hoher Feuchtigkeit verbessert und die Möglichkeiten einer erfolgreichen Durchführung bzw. Absolvierung von Tests, wie beispielsweise HAST, unter Verringerung des Anteils von Ausschußprodukten gesteigert werden.

Zur Lösung dieser Aufgaben ist das Verfahren der eingangs genannten Art im wesentlichen dadurch gekennzeichnet, daß die Leiterbahnen nach der Reinigungsbehandlung mit wenigstens einer komplexbildenden Zusammensetzung behandelt werden. Da vor der weiteren Bearbeitung, insbesondere dem Aufbringen der Lötmaske oder Ausbilden einer weiteren Leiterplattenlage eine Vorbehandlung für die Leiterbahnen vorgesehen wird, in welch an der Oberfläche der Leiterbahnen berindliche Ionen und/oder lonenverunreinigungen durch eine Reinifläche der Leiterbahnep befindliche Ionen und/oder Ionenverunreinigungen durch eine Reinigungsbehandlung entfernt werden, wonach Leiterbahnen mit wenigstens einer komplexbildenden Zusammensetzung behandelt werden, gelingt es, nach dieser Behandlung bzw. Vorbehandlung an der Oberfläche der Leiterbahnen im wesentlichen metallisches Kupfer oder Kupferkomplexe zur Verfügung zu stellen, dessen (deren) Vorhandensein in weiterfolgenden Bearbeitungsschritten, beispielsweise nach bzw. bei Aufbringen einer Lötmaske und für ein Härten einer Lötmaske auftretenden erhöhten Temperaturen insbesondere die Ausbildung von Kupferoxid vermeidet bzw. weitestgehend reduziert. Derartiges Kupferoxid würde in weiterer Folge bei einem Einsatz einer derartigen Leiterplatte bei Bedingungen hoher Temperatur und hoher Feuchtigkeit, wie beispielsweise bei Durchführung bzw. Überprüfung mittels HAST, eine Mikroumgebung ausbilden bzw. zur Verfügung stellen, welche die oben genannten Mechanismen eines Ausbildens bzw. eines Wachstums von Kupferfilamenten und/oder Kupferdendriten begünstigt, so daß in weiterer Folge derartige Leiterbahnen bzw. derartige Leiterbahnen aufweisende Leiterplatten den Anforderungen nicht genügen. Durch die Reinigungsbehandlung werden Kupferionen und/oder lonenverunreinigungen an der Oberfläche der Leiterbahnen weitestgehend entfernt, so daß beispielsweise bei einem nachfolgenden Be- bzw. Verarbeitungsschritt durch den weitestgehende Mangel an Kupferionen eine Ausbildung insbesondere von Kupferoxid weitestgehend ausgeschaltet bzw. vermieden wird, so daß in weiterer Folge die für die oben genannten Phänomene bzw. Mechanismen einer Ausbildung von Kupferdendriten oder Kupferfilamenten erforderlichen bzw. günstigen Bedingungen nicht bzw. nicht mehr gegeben sind. Darüber hinaus gelingt es durch Behandlung mit einer komplexbildenden Zusammensetzung ebenfalls die Anzahl von Kupferionen auf der Oberfläche einer Leiterbahn stark zu reduzieren oder zu minimieren, wodurch ebenfalls in weiterer Folge und insbesondere bei Einsatz in Umgebungen hoher relativer Feuchtigkeit die mit einem Wachstum von Kupferdendriten oder Kupferfilamenten verbundenen Probleme vermieden werden können und entsprechende Überprüfungen bzw. Tests erfolgreich absolviert werden können. Darüber hinaus ist davon auszugehen, daß auch gegebenenfalls in Nahebereichen von Leiterbahnen, insbesondere auf einem Dielektrikum vorgesehene bzw. befindliche freie Kupferionen durch die vorgeschlagene Behandlung mit einer Ionen entfernenden Reinigungslösung und mit wenigstens einer komplexbildenden Zusammensetzung entfernt werden, so daß auch derartige, ursprünglich beispielsweise auf der Oberfläche eines Dielektrikums vorhandene freie Kupferionen insbesondere in Bereichen eines geringen gegenseitigen Abstands zwischen benachbarten Leiterbahnen in weiterer Folge die für eine Ausbildung von Kupferdendriten oder Kupferfilamenten günstigen Bedingungen nicht mehr bereitstellen können.

Es gelingt somit durch Vorsehen eines einfachen Reinigungsschritts und einer erfindungsgemäßen Behandlung mit einer komplexbildenden Zusammensetzung vor einer weiteren Bearbeitung eine Oberfläche einer aus Kupfer bestehenden Leiterbahn zur Verfügung zu stellen, welche im wesentlichen metallisches Kupfer oder Kupferkomplexe und jedenfalls eine stark verringerte Anzahl von freien Kupferionen und/oder lonenverunreinigungen aufweist, so daß in nachfolgenden Bearbeitungsschritten und insbesondere einer nachfolgenden Behandlung bei erhöhter Temperatur nicht mehr die Basis für eine Ausbildung von Kupferoxid vorhanden ist Ein derartiger Vorbehandlungsschritt kann beispielsweise mit bekannten Reinigungsschritten kombiniert werden oder diese weitestgehend ersetzen, so daß zur Erzielung der verbesserten Korrosionsbeständigkeit insbesondere bestehende Herstellungsanlagen von Leiterplatten nicht modifiziert werden müssen, sondern lediglich insbesondere zu einer Reinigungsbehandlung eingesetzte Stoffe bzw. Substanzen teilweise ersetzt oder ergänzt werden.

Zur Erzielung einer ordnungsgemäßen und zuverlässigen Entfernung von freien Ionen und/oder lonenverunreinigungen an der Oberfläche der Leiterbahnen wird gemäß einer bevorzugten Ausführungsform des erfindungsgemäßen Verfahrens vorgeschlagen, daß die Reinigungsbehandlung mit wenigstens einer reduzierenden oder ätzenden Zusammensetzung durchgeführt wird. Derartige reduzierende oder ätzende Zusammensetzungen ermöglichen eine zuverlässige Entfernung von freien Ionen und gegebenenfalls lonenverunreinigungen, wie beispielsweise Kupferhydroxid an der Oberfläche der Leiterbahnen und gegebenenfalls im Nahebereich derartiger Leiterbahnen auf einem Dielektrikum, wobei in diesem Zusammenhang gemäß einer weiters bevorzugten Ausführungsform des erfindungsgemäßen Verfahrens vorgeschlagen wird, daß für die Reinigungsbehandlung Schwefelsäure eingesetzt wird. Zur Erzielung des gewünschten Reinigungseffekts durch Entfernung der Oberfläche der Leiterbahnen sowie unter Berücksichtigung der üblicherweise eine geringe Dicke und/oder Höhe aufweisenden Leiterbahnen wird hiebei ergänzend vorgeschlagen, daß Schwefelsäure mit einer maximalen Konzentration von 35 % eingesetzt wird.

Zur weiteren Verbesserung der Reinigungsbehandlung bzw. Entfernungswirkung der an der Oberfläche der Leiterbahnen befindlichen Ionen und/oder Ionenverunreinigungen und gegebenenfalls unter Berücksichtigung von in vorangehenden Bearbeitungsschritten eingesetzten Materialien, welche gegebenenfalls gleichzeitig mit der Entfernung der freien Ionen entfernt werden sollen, wird gemäß einer weiters bevorzugten Ausfuhrungsform vorgeschlagen, daß für die Reinigungsbehandlung eine Mischung aus Schwefelsäure und einem zusätzlichen reduzierenden Mittel, gewählt aus der Gruppe, enthaltend Wasserstoffperoxid, Ameisensäure, Salzsäure, Phenolsulfonsäure oder dgl., eingesetzt wird. Derartige zusätzliche reduzierende und/oder ätzende Mittel bzw. Agenzien sind wenigstens teilweise bei der Bearbeitung bzw. Behandlung von Leiterplatten bekannt, so daß, wie oben bereits erwähnt, das erfindungsgemäße Verfahren auch auf bestehenden Herstellungsanlagen für Leiterplatten eingesetzt werden kann und beispielsweise vorzusehende Reinigungsschritte ersetzt oder ergänzt.

Im Zusammenhang mit der Ausbildung von Kupferkomplexen wird gemäß einer weiters bevor zugten Ausführungsform vorgeschlagen, daß als komplexbildende Zusammensetzung Ammoniak verwendet wird. Eine Ausbildung derartiger Kupferkomplexe stellt wiederum sicher, daß freie, an der Oberfläche befindliche Kupferionen und/oder lonenverunteinigungen insbesondere durch Ausbildung sehr stabiler Komplexe entfernt bzw. ersetzt werden, so daß wiederum, wie bereits oben angeführt im Rahmen weiterer Behandlungsschritte die Voraussetzungen für die Ausbildung insbesondere von Kupferoxid verschlechtert werden. Dadurch werden in weiterer Folge die Voraussetzungen für eine Ausbildung oder ein Wachstum von Kupferdendriten oder Kupferfilamenten insbesondere bei einem Eintritt bzw. Einsatz einer derartigen, durch das erfindungsgemäße Verfahren hergestellten Leiterplatte in Umgebungen hoher Feuchtigkeit reduziert oder minimiert und es wird somit die Güte der hergestellten Leiterplatten stark verbessert.

Anstelle der Ausbildung von Kupferkomplexen unter Einsatz von Ammoniak können auch insbesondere organische Kupferkomplexe an der Oberfläche von Leiterbahnen gebildet werden, wobei in diesem Zusammenhang gemäß einer weiters bevorzugten Ausführungsform vorgeschlagen wird, daß wenigstens eine organische komplexbildende Zusammensetzung, wie beispielsweise EDTA, Kaliumhydrogentartrat. Ethylendiamin, Nitriltriessigsäure und dgl. verwendet wird.

Für eine besonders einfache Durchführung des erfindungsgemaßen Verfahrens wird vorgeschlagen, daß die Reinigungsbehandlung und/oder die Behandlung mit einer komplexbildenden Zusammensetzung in einem Sprühverfahren durchgeführt wird, wie dies einer weiters bevorzugten Ausführungsform des erfindungsgemäßen Verfahrens entspricht.

Zur Erzielung der gewünschten Reinigung oder Ausbildung einer komplexbildenden Schicht wird gemäß einer weiters bevorzugten Ausführungsform vorgeschlagen, daß die Reinigungsbehandlung und/oder die Behandlung mit einer komplexbildenden Zusammensetzung bei Temperaturen unter 50 °C, insbesondere unter 40 °C und für eine Dauer von wenigstens 1 s, insbesondere wenigstens 10 s, durchgeführt wird, so daß mit Behandlungen kurzer Dauer und bei vergleichsweise niedrigen Temperaturen das Auslangen gefunden werden kann.

Wie oben bereits erwähnt, gelingt durch eine Reinigungsbehandlung zur Entfernung von freien an der Oberfläche befindlichen Ionen bzw. lonenverunreinigungen und durch Ausbildung von Komplexen die Bereitstellung insbesondere einer Oberflächenstruktur derartiger Leiterbahnen, welche in weiteren Behandlungsschritten insbesondere bei erhöhten Temperaturen die Ausbildung insbesondere von Kupferoxid stark reduziert oder minimiert. Zur weiteren Verbesserung der Oberflächeneigenschaften zur Verhinderung der Ausbildung derartiger Kupferoxide an der Oberfläche, wobei dies in weiterer Folge die Ausbildung von Kupferdendriten oder Kupferfilamenten verhindert oder zumindest stark reduziert, wird gemäß einer weiters bevorzugten Ausführungsform des erfindungsgemäßen Verfahrens vorgeschlagen, daß nach Durchführung der Reinigungsbehandlung und der Behandlung mit wenigstens einer komplexbildenden Zusammensetzung eine Schutzschicht auf die Leiterbahnen aufgebracht wird. Somit gelingt nach der Bereitstellung einer im wesentlichen metallischen Oberfläche der Leiterbahn oder einer mit sehr stabilen Komplexen versehenen Oberfläche der Leiterbahn eine zusätzliche Versiegelung der Oberfläche der Leiterbahn gegenüber einer Ausbildung insbesondere von Kupferoxid, wodurch eine Reduzierung oder Vermeidung einer Ausbildung von Kupferdendriten oder Kupferfilamenten bei einem Einsatz derartiger Leiterplatten insbesondere in Umgebungen hoher Feuchtigkeit weiter verbessert wird. In diesem Zusammenhang wird darüber hinaus vorgeschlagen, daß als Schutzbeschichtung ein organisches Konservierungsmittel, insbesondere ein organisches Kupferoberflächenkonservierungsmittel zum Erhalt der Lötbarkeit aufgebracht wird, wie dies einer weiters bevorzugten Ausführungsform des erfindungsgemäßen Verfahrens entspricht.

Zur weiteren Minimierung der Ausbildung von Kupferdendriten oder Kupferfilamenten bei einem nachfolgenden Einsatz einer fertiggestellten Leiterplatte in Umgebungen hoher Feuchtigkeit wird gemäß einer weiters bevorzugten Ausführungsform vorgeschlagen, daß die weitere Behandlung nach einem Zeitraum von höchstens 48 Stunden, insbesondere höchstens 10 Stunden nach Durchführung der Reinigungsbehandlung und/oder der Behandlung mit wenigstens einer komplexbildenden Zusammensetzung und/oder der Aufbringung der Schutzschicht durchgeführt wird. Unter Einhaltung des erfindungsgemäß vorgeschlagenen, maximalen Zeitraums von 48 Stunden nach Durchführung der Reinigungsbehandlung und/oder der Behandlung mit wenigstens einer komplexbildenden Zusammensetzung und/oder der Aufbringung der Schutzschicht wird sichergestellt, daß die gewünschten günstigen Eigenschaften der Bereitstellung einer metallischen Oberfläche oder einer Oberfläche mit stabilen Komplexen, welche gegebenenfalls zusätzlich durch Aufbringung einer Schutzschicht geschützt ist, während nachfolgender Behandlungsschritte beibehalten werden können. Bei einem Überschreiten des angegebenen Zeitraums vor einer weiteren Bearbeitung sollte günstigerweise eine neuerliche Reinigungsbehandlung und/oder Behandlung mit wenigstens einer komplexbildenden Zusammensetzung, wenn auch gegebenenfalls in einer verkürzten Zeitdauer durchgeführt werden, um die gewünschten günstigen Eigenschaften zur Verhinderung eines Wachstums von Kupferdendriten oder Kupferfilamenten in weiterer Folge aufrecht zu erhalten bzw. zur Verfügung zu stellen.

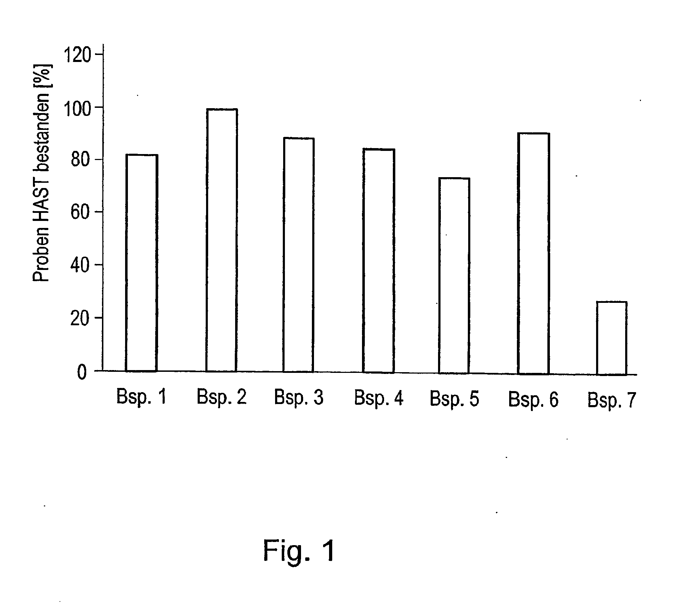

Die Erfindung wird nachfolgend anhand von Ausführungsbeispielen des erfindungsgemäßen Verfahrens im Detail erläutert. Darüber hinaus zeigt Fig. 1 ein Diagramm, in welchem die bei einer Behandlung mit dem erfindungsgemäßen Verfahren erzielbaren Verbesserungen eines erfolgreichen Bestehens des HAST im Vergleich zu einer herkömmlichen Behandlung einer Leiterplatte ersichtlich sind.

Einleitend soll kurz der Mechanismus erörtert werden, gemäß welchem bei bekannten Herstellungsverfahren bei einem nachfolgenden Einsatz einer Leiterplatte in Umgebungen hoher Feuchtigkeit und beispielsweise während der Durchführung von HAST bei einer Temperatur von 110 °C und einer relativen Feuchtigkeit von 85 % insbesondere ein Wachstum von Kupferdendriten oder Kupferfilamenten zu einem Versagen einer derartigen Leiterplatte durch Kurzschlüsse führt.

Nach einer Herstellung von Leiterbahnen einer Leiterplatte aus Kupfer, welche beispielsweise eine geringe Breite und einen entsprechend geringen gegenseitigen Abstand von beispielsweise weniger als 50 Mikrometer aufweisen, existieren freie Kupferionen oder existiert Cu(OH)₂ nach einem Fotostrippen beispielsweise mit NaOH an der Oberfläche von Leiterbahnen oder im unmittelbaren Nahebereich an der Oberfläche eines die Leiterbahn umgebenden Dielektrikums. Während nachfolgender Bearbeitungsschritte, beispielsweise einem Vorreinigen vor Aufbringen einer Lötmaske und einer nachfolgenden Härtung einer Lötmaske bei Temperaturen von üblicherweise mehr als 80 °C reagiert Kupferhydroxid zu Kupferoxid, wobei derartiges Kupferoxid viel schwerer zu lösen und von der Oberfläche zu entfernen ist im Vergleich zu Kupferhydroxid.

Wenn ein derartiges Kupferoxid in weiterer Folge nach Herstellung der Leiterbahnen bzw. der die Leiterbahnen aufweisenden Leiterplatten einer Umgebung hoher Feuchtigkeit und gegebenenfalls hoher Temperatur, wie beispielsweise während einer Überprüfung durch HAST ausgesetzt wird, ist derartiges Kupferoxid fähig, eine Mikroumgebung zur Verfügung zu stellen bzw. auszubilden, welche ein Wachstum bzw. eine Ausbildung von Kupferfilamenten und/oder Kupferdendriten begünstigt. Derartige Kupferfilamente und/oder Kupferdendrite führen in weiterer Folge während derartiger Tests oder allgemein einem Einsatz unter Bedingungen hoher Feuchtigkeit zu Kurzschlüssen zwischen Leiterbahnen mit einem entsprechend geringen wechselseitigen Abstand und somit insgesamt zu einem Versagen derartiger Leiterplatten.

Das erfindungsgemäße Verfahren stellt demgegenüber vor einer weiteren Bearbeitung unter insbesondere erhöhter Temperatur, insbesondere vor einem Aufbringen einer Lötmaske oder der Aufbringung einer weiteren Leiterplattenlage, und einem nachfolgenden Härten der Lötmaske eine Vorbehandlung zur Verfügung, welche ermöglicht, freie Kupferionen oder gegebenenfalls Ionen von Verunreinigungen, wie beispielsweise bereits gebildetes Kupferhydroxid von der Oberfläche der Leiterbahnen und gegebenenfalls auch benachbarten Nahbereichen der Leiterbahnen von einem Dielektrikum zu entfernen. Dies ermöglicht darüber hinaus vor nachfolgenden Behandlungsschritten, insbesondere unter Aussetzen an höhere Temperaturen und erhöhte Feuchtigkeit, die Ausbildung insbesondere von Kupferoxid zu verhindern bzw. weitestgehend zu reduzieren, welches wiederum, wie oben ausgeführt, günstige Bedingungen für ein Wachstum von Kupferdendriten oder Kupfefilamenten zur Verfügung stellt und ein nachfolgendes Versagen einer derartigen Leiterplatte insbesondere bei einem Einsatz in Umgebungen hoher Feuchtigkeit mit sich bringt.

Zur Vermeidung einer derartigen Ausbildung insbesondere von Kupferoxid in nachfolgenden Behandlungsschritten werden nachfolgend drei Gruppen von Behandlungsverfahren im Detail erörtert, welche bei einem getrennten Einsatz jeweils bereits eine starke Verbesserung im Hinblick auf eine Verbesserung der Korrosionsbeständigkeit einer elektronischen Komponente, insbesondere von Leiterbahnen einer Leiterplatte ergeben, wie sich dies auch aus dem in Fig. 1 dargestellten Diagramm ableiten läßt, welches nachfolgend im Detail erörtert werden wird. Bei kumulativer Anwendung von wenigstens zwei der nachfolgend genannten Verfahrensführungen lassen sich die erzielbaren Ergebnisse im Hinblick auf eine Verbesserung der Korrosionsbeständigkeit entsprechend verbessern.

### 1. Reinigungsbehandlung mit einer reduzierenden oder ätzenden Zusammensetzung

Anstelle eines Reinigens einer Leiterbahn mit Wasser oder Säure- und Ätzlösungen geringer Konzentration, wie dies bei bekannten Verfahren der Fall ist, wird der Einsatz beispielsweise folgender Reinigungs- bzw. Ätzlösungen zur Bereitstellung einer Oberfläche von Leiterbahnen vorgeschlagen, welche frei von Kupferionen oder Kupferionenverunreinigungen, wie beispielsweise Kupferhydroxid sind und somit im wesentlichen metallisches Kupfer zur Verfügung stellen. Bei den nachfolgend genannten Reinigungslösungen ist davon auszugehen, daß die eingesetzten Säuren in konzentrierter Form vorliegen.

Als Reinigungs- bzw. Ätzlösung werden die folgenden Lösungen vorgeschlagen, wobei darüber hinaus bei jeder Lösung weitere Parameter als Angaben für Temperatur, Behandlungsdauer, Aufbringungsart etc. angegeben sind.
a) Reinigungslösung 1
   H₂SO₄: 5,5 %
   HCl: 5,5 %
   Rest H₂O

   Die Reinigungslösung wird in einem Sprühverfahren eingesetzt, wobei die Behandlung bei einer Temperatur von 25 °C und für eine Dauer von 30 s vorgenommen wird.
b) Reinigungslösung 2
   H₂SO₄: 2 %
   HCl: 2 %
   Rest: H₂O

   Die Reinigungslösung wird in einem Sprühverfahren eingesetzt, wobei die Behandlung bei einer Temperatur von 30 °C und für eine Dauer von 60 s vorgenommen wird.
c) Reinigungslösung 3
   H₂SO₄: 2,5 %
   HCl: 1 %
   Ameisensäure: 1 %
   Rest H₂O

   Die Reinigungslösung wird in einem Sprühverfahren eingesetzt, wobei die Behandlung bei einer Temperatur von 40 °C und für eine Dauer von 20 s vorgenommen wird.
d) Reinigungslösung 4
   H₂SO₄: 4 %
   HCl: 1 %
   Ameisensäure: 1,5 %
   Rest: H₂O

   Die Reinigungslösung wird in einem Sprühverfahren eingesetzt, wobei die Behandlung bei einer Temperatur von 40 °C und für eine Dauer von 30 s vorgenommen wird.
e) Reinigungslösung 5
   Kaliummonopersulfat: 1 %
   H₂SO₄: 2, 5 %
   Rest: H₂O

   Die Reinigungslösung wird in einem Sprühverfahren eingesetzt, wobei die Behandlung bei einer Temperatur von 32 °C und für eine Dauer von 30 s vorgenommen wird.

Es kann somit mit Lösungen geringer Konzentration bzw. Anteile an Säuren das Auslangen gefunden werden, welche auch bei vergleichsweise niedrigen Temperaturen und kurzer Behandlungsdauer die gewünschten Reinigungseffekte ermöglichen. Zur weiteren Verkürzung der Behandlungsdauer und somit gewünschtenfalls Beschleunigung des Verfahrens könnten entsprechend höhere Konzentrationen bzw. Anteile der Säuren eingesetzt werden.

Nach einer derartigen Behandlung mit einer zumindest Schwefelsäure enthaltenden Reinigungs- bzw. Ätzlösung bzw. -zusammensetzung wird eine von Kupferionen oder lonenverunreinigungen im wesentlichen freie, metallische Oberfläche der Leiterbahn als auch eine von Kupferionen oder Verunreinigungen freie Oberfläche eines angrenzenden Dielektrikums zur Verfügung gestellt.

Nach einem nachfolgenden Bearbeitungsschritt insbesondere unter erhöhter Temperatur, beispielsweise einem Aufbringen einer Lötmaske und einem Härten bei erhöhten Temperaturen von beispielsweise mehr als 80 °C oder Aufbringen einer zusätzlichen bzw. weiteren Leiterplattenlage, findet eine Ausbildung von Kupferoxid an der Oberfläche durch das Fehlen von freien Kupferionen und insbesondere von Kupferhydroxid nicht statt, so daß bei einer Fertigstellung einer derartigen Leiterbahn oder mit derartigen Leiterbahnen versehenen Leiterplatten in weiterer Folge selbst bei einem Einsatz derselben in Umgebung erhöhter Feuchtigkeit und gegebenenfalls erhöhter Temperatur das üblicherweise zu einem Versagen einer derartigen Leiterplatte führende Wachstum von Kupferdendriten oder Kupferfilamenten unter Ausbildung von Kurzschlüssen zwischen Leiterbahnen mit geringem gegenseitigen Abstand weitestgehend reduziert oder vollständig vermieden werden kann.

### 2. Komplexieren von Kupferionen

a) Behandlung der Oberfläche von Leiterbahnen mit Ammoniak (beispielsweise 0,5 %) zur Ausbildung von stabilen Komplexen, beispielsweise Cu(NH₃)+.
   Hiebei wird eine wäßrige Ammoniaklösung mit einem pH-Wert zwischen 8,7 und 9,7 eingesetzt, wobei die Einstellung des pH-Werts mit konzentrierter NH3 erfolgt. Die Komplexierung wird in einem Sprühverfahren bei 25 °C für 30 s durchgeführt.
b) Ausbildung von anderen Kupferkomplexen, wie beispielsweise Cu(CN)².
c) Ausbildung von organischen Komplexen,
d) Einsatz von wenigstens etwa 1 %-igen Lösungen von EDTA, Kaliumhydrogentartrat, Ethylendiamin, Nitriltriessigsäure oder dgl.

Zur Behandlung mit Kaliumhydrogentartrat wird eine 1 %-ige Lösung eingesetzt, wobei eine Behandlungstemperatur von 25 °C gewählt wird und die Behandlung in einem Sprühverfahren für 30 s durchgeführt wird.

Durch Ausbildung derartiger, stabiler Komplexe wird ebenso wie bei der Ausbildung bzw. Bereitstellung von metallischem Kupfer bei einer Reinigungsbehandlung mit einer gemäß den unter Gruppe 1 vorgeschlagenen Reinigungslösungen in weiterer Folge verhindert, daß beispielsweise durch Ausbildung von Kupferoxid bei einem Einsatz in Umgebungen hoher Feuchtigkeit und hoher Temperatur eine Ausbildung von Kupferdendriten oder Kupferfilamenten auftritt und dies in weiterer Folge zu einem Versagen derartiger Leiterplatten durch Kurzschlüsse führt.

### 3. Ausbilden bzw. Aufbringen einer Schutzschicht

Im Zusammenhang mit der Aufbringung einer Schutzschicht zum Schutz von Leiterbahnen und insbesondere zur Verhinderung von Kupferoxid ist es beispielsweise bekannt, in einem insbesondere zweistufigen Verfahren in einem ersten Verfahrensschritt ein Vorbehandeln bzw. Vorbeschichten einer aus Kupfer bestehenden Oberfläche einer Leiterbahn durchzuführen, worauf in einem zweiten Verfahrensschritt eine Schutzschicht aus einem organischen Konservierungsmittel, insbesondere organischen Kupferobertlächenkonservierungsmittel zum Erhalt der Lötbarkeit aufgebracht wird. Im Rahmen der Vorbehandlung wird der aus Kupfer bestehenden Leiterbahn durch Aufbringen einer organischen Schutzschicht eine Selektivität für das gegebenenfalls in weiterer Folge zusätzlich aufzubringende Konservierungsmittel verliehen, wobei sich, wie dies nachfolgend anhand des in Fig. 1 dargestellten Diagramms im Detail erörtert werden wird, gezeigt hat, bereits lediglich die Durchführung der Vorbehandlung unter Aufbringung einer organischen Vorbeschichtung eine gewünschten Erhöhung der Korrosionsbeständigkeit erzielen läßt.

Eine derartige Schutzbeschichtung verhindert nicht nur ebenfalls die Ausbildung von Kupferoxid, sondern kann auch zur pH Regulierung der nachfolgenden Verfahrens- bzw. Bearbeitungsschritte eingesetzt werden.

Die Ausbildung bzw. Aufbringung derartiger Schutzschichten ist derzeit beispielsweise im Zusammenhang mit einem Erhalt der Lötbarkeit von Leiterbahnen bekannt, wobei derartige, insbesondere zweistufige Verfahren eingesetzt bzw. verwendet werden.

Der Einsatz einer derartigen Ausbildung bzw. Aufbringung einer Schutzschicht bzw. zumindest einer Vorbeschichtung bzw. eines pre-coats im Rahmen eines an sich bekannten derartigen zweistufigen Verfahrens ermöglicht darüber hinaus, wie dies anhand einer Vielzahl von Überprüfungen festgestellt wurde, welche weiters zu den in Fig. 1 dargestellten, weiteren Verbesserungen der Korrosionsbeständigkeit geführt haben, darüber hinaus beispielsweise eine pH-Wert-Änderung in der Mikroumgebung der unmittelbaren Oberfläche einer hergestellten Leiterbahn, eine Änderung der lonenstärke oder dgl., um in weiterer Folge günstige Bedingungen zur Erhöhung der Korrosionsbeständigkeit zur Verfügung zu stellen. Derzeit bekannte Verfahren einer Ausbildung einer Schutzschicht, welche insbesondere auf einen Erhalt bzw. eine Verbesserung der Lötbarkeit abzielen, lassen sich somit in wenigstens teilweise überraschender Weise auch zur Einstellung bzw. Beeinflussung weiterer Parameter heranziehen, welche eine weitere Verarbeitbarkeit und einen Einsatz einer derart hergestellten bzw. bearbeiteten Leiterplatte und insbesondere deren Korrosionsbeständigkeit in feuchten Umgebungen verbessern.

In dem in Fig. 1 dargestellten Diagramm sind für verschiedene Ausführungsbeispiele einer Behandlung von Leiterbahnen einer Leiterplatte mit den nachfolgend angegebenen Behandlungsschritten jeweils in einem Balkendiagramm Prozentsätze angegeben, inwieweit nach der entsprechend der nachfolgenden Liste angeführten Behandlungen gemäß den Beispielen zu testende Leiterplatten HAST bestanden haben.

Für die einzelnen, in Fig. 1 gezeigten Beispiele wurden folgende Behandlungen nach einem Ausbilden von aus Kupfer gebildeten Leiterbahnen und gegebenenfalls nachfolgenden Bearbeitungen durchgeführt. Die angegebenen Reinigungslösungen oder Komplexierung sowie die Ausbildung einer Schutzschicht beziehen sich jeweils auf die oben unter Punkt 1, 2 und 3 angegebenen Verfährensführungen bzw. Lösungen.

### Beispiel 1: (nicht von Erfindung umfaßt)

### Reinigungslösung 4

### Beispiel 2:

### Reinigungslösung 4 + Reinigungslösung 5 + Komplexierung 2a + organische Schutzschicht (Vorbeschichtung gemäß Punkt 3, pre-coat)

### Beispiel 3:

### Reinigungslösung 1 + Reinigungslösung 2 + Komplexierung 2a + organische Schutzschicht (pre-coat gemäß Punkt 3)

### Beispiel 4:

### Reinigungslösung 5 + Komplexierung 2a

### Beispiel 5: (nicht von Erfindung umfaßt)

### Reinigungslösung 1 + Reinigungslösung 2

### Beispiel 6:

### Reinigungslösung 4 + Reinigungslösung 5 + Komplexierung 2a + organische Schutzschicht (pre-coat gemäß Punkt 3) + organische Schutzschicht gemäß Punkt 3

### Beispiel 7:

### herkömmliche Behandlung einer Leiterplatte nach Ausbildung der Leiterbahn ohne eine Lösung oder einen Verfahrensschritt wenigstens einer der Gruppen 1 bis 3, welche oben im Detail angeführt sind.

Aus der Darstellung gemäß Fig. 1 ist ersichtlich, daß bei Einsatz der erfindungsgemäßen Verfahrensschritte eine starke Verbesserung des Prozentsatzes an Proben erzielbar ist, welche HAST bestehen.

Es hat sich gezeigt, daß bei einem Einsatz von herkömmlichen Verfahrensbedingungen gemäß Beispiel 7 etwa 25 % der Proben HAST bestehen, während durch Einsatz einer Behandlung mit wenigstens einer Reinigungslösung eine Verbesserung erzielbar ist, wie dies in Beispiel 1 und 5 ersichtlich ist, welche nicht durch die Erfindung umfaßt sind.

Bei zusätzlichem Vorsehen einer Komplexierung gemäß Beispiel 4 läßt sich der Prozentsatz an Proben, welche HAST bestehen, auf etwa 85 % erhöhen.

Weitere Verbesserungen lassen sich durch zusätzliches Vorsehen zumindest einer organischen Schutzschicht in Form einer Vorbeschichtung als auch einer zusätzlichen organischen Schicht gemäß dem unter Punkt 3 genannten zweistufigen Verfahren erzielen, wobei sich aus einem Vergleich der Beispiele 2, 3 und 6 ergibt, daß sich das beste Ergebnis bei Beispiel 2 lediglich bei Verwendung einer organischen Schutzschicht als Vorbeschichtung erzielen läßt, wobei ein Prozentsatz von 100 % erfolgreichen Proben erzielt wurde.

Zu den in Fig. 1 dargestellten Prozentsätzen wird darüber hinaus angemerkt, daß eine Überprüfung mittels HAST jeweils an einer Vielzahl von entsprechend den Beispielen 1 bis 7 behandelten Proben vorgenommen wurde, wobei für die Ermittlung des Prozentsatzes für jedes Ausführungsbeispiel gemäß Beispiel 1 bis 6 wenigstens 50 Proben einer Überprüfung unterzogen wurden, während für Beispiel 7 35 Proben untersucht wurden.

Es läßt sich somit aus Fig. 1 deutlich ersehen, daß bereits durch Vorsehen bzw. Einsatz einer Vorbehandlung in Form einer Reinigungsbehandlung zur Entfernung von an der Oberfläche der Leiterbahnen befindlichen Ionen oder Ionenverunreinigungen eine beträchtliche Erhöhung der Korrosionsbeständigkeit von elektronischen Komponenten, insbesondere von Leiterbahnen einer Leiterplatte erzielbar ist, wie dies beispielsweise mit einem standardisierten HAST untersucht wird.

Darüber hinaus ist ersichtlich, daß bei zusätzlicher Vornahme einer Komplexierung und gegebenenfalls Ausbildung einer organischen Schutzschicht in Form einer Vorbeschichtung weitere Verbesserungen der Korrosionsbeständigkeit erzielbar sind, wie sich dies aus einer weiteren Verbesserung bzw. Erhöhung des Prozentsatzes an Proben ableiten läßt, welche erfolgreich HAST bestehen, wobei insbesondere bei einem Einsatz einer Kombination von Reinigungslösungen als auch einer Komplexierung der Ausbildung einer organischen Schutzschicht im Sinn einer Vorbeschichtung sämtliche Proben HAST bestehen.

Für eine weiterfolgende Behandlung nach Durchführung wenigstens eines der unter Punkt 1) bis 3) genannten Verfahren wird zur Vermeidung von Umwelteinflüssen während der Lagerung der Leiterbahnen darauf abgezielt, eine weitere Behandlung nach einem Zeitraum von höchstens 48 Stunden, günstigerweise höchstens 10 Stunden durchzuführen.

Sollte ein derartiger Zeitraum vor der weiteren Behandlung überschritten werden, so sollte die jeweilige Verfahrensführung gemäß wenigstens einem der Punkte 1) bis 3) zumindest in verkürzter Zeitdauer wiederholt werden, um während nachfolgender Verfahrensschritte die Ausbildung von Kupferoxid zu vermeiden.

## Patentansprüche

1. Verfahren zum Verbessern der Korrosionsbeständigkeit einer elektronischen Komponente, insbesondere von Leiterbahnen einer Leiterplatte, wobei nach einem Ausbilden von aus Kupfer gebildeten Leiterbahnen diese einer Vorbehandlung unterworfen werden, in welcher an der Oberfläche der Leiterbahnen befindliche Ionen oder Ionenverunreinigungen durch eine Reinigungsbehandlung entfernt werden, **dadurch gekennzeichnet, daß** die Leiterbahnen nach der Reinigungsbehandlung mit wenigstens einer komplexbildenden Zusammensetzung behandelt werden.

2. Verfahren nach Anspruch 1, **dadurch gekennzeichnet, daß** die Reinigungsbehandlung mit wenigstens einer reduzierenden oder ätzenden Zusammensetzung durchgeführt wird.

3. Verfahren nach Anspruch 1 oder 2, **dadurch gekennzeichnet, daß** für die Reinigungsbehandlung Schwefelsäure eingesetzt wird.

4. Verfahren nach Anspruch 3, **dadurch gekennzeichnet, daß** für die Reinigungsbehandlung eine Mischung aus Schwefelsäure und einem zusätzlichen reduzierenden Mittel, gewählt aus der Gruppe enthaltend Wasserstoffperoxid, Ameisensäure, Salzsäure, Phenolsulfonsäure oder dgl. eingesetzt wird.

5. Verfahren nach einem der Ansprüche 1 bis 4, **dadurch gekennzeichnet, daß** als komplexbildende Zusammensetzung Ammoniak verwendet wird.

6. Verfahren nach einem der Ansprüche 1 bis 4, **dadurch gekennzeichnet, daß** wenigstens eine organische komplexbildende Zusammensetzung, wie beispielsweise EDTA, Kaliumhydrogentartrat Ethylendiamin, Nitriltriessigsäure und dgl. verwendet wird.

7. Verfahren nach einem der Ansprüche 1 bis 6. **dadurch gekennzeichnet, daß** die Reinigungsbehandlung und/oder die Behandlung mit einer komplexbildenden Zusammensetzung in einem Sprühverfahren durchgeführt wird.

8. Verfahren nach einem der Ansprüche 1 bis 7, **dadurch gekennzeichnet, daß** die Reinigungsbehandlung und/oder die Behandlung mit einer komplexbildenden Zusammensetzung bei Temperaturen unter 50 °C. insbesondere unter 40 °C und für eine Dauer von wenigstens 1 s, insbesondere wenigstens 10 s, durchgeführt wird.

9. Verfahren nach einem der Ansprüche 1 bis 8, **dadurch gekennzeichnet, daß** nach Durchführung der Reinigungsbehandlung und der Behandlung mit wenigstens einer komplexbildenden Zusammensetzung eine Schutzschicht auf die Leiterbahnen aufgebracht wird.

10. Verfahren nach Anspruch 9, **dadurch gekennzeichnet, daß** als Schutzbeschichtung ein organisches Konservierungsmittel, insbesondere ein organisches Kupferoberflächenkonservierungsmittel zum Erhalt der Lötbarkeit aufgebracht wird.

11. Verfahren nach einem der Ansprüche 1 bis 10, **dadurch gekennzeichnet, daß** die weitere Behandlung nach einem Zeitraum von höchstens 48 Stunden, insbesondere höchstens 10 Stunden nach Durchführung der Reinigungsbehandlung und/oder der Behandlung mit wenigstens einer komplexbildenden Zusammensetzung und/oder der Aufbringung der Schutzschicht durchgeführt wird.

## Claims

1. A method for improving the corrosion resistance of an electronic component, particularly of conductors of a printed circuit board, wherein after the conductors are produced out of copper, these are subjected to a pretreatment prior to the further treatment, wherein ions and/or ion impurities present on the surface of the conductors are removed by a purifying treatment, **characterized in that** after the purifying treatment the conductors are treated with at least one complexing composition.

2. A method according to claim 1, **characterized in that** the purifying treatment is performed with at least one reducing or etching composition.

3. A method according to claim 1 or 2, **characterized in that** sulfuric acid is used for the purifying treatment.

4. A method according to claim 3, **characterized in that** a mixture of sulfuric acid and an additional reducing agent selected from the group consisting of hydrogen peroxide, formic acid, hydrochloric acid, phenolsulfonic acid or the like is used for the purifying treatment.

5. A method according to any one of claims 1 to 4, **characterized in that** ammonia is used as a complexing composition.

6. A method according to any one of claims 1 to 4, **characterized in that** at least one organic complexing composition such as, for instance, EDTA, potassium hydrogen tartrate, ethylenediamine, nitrilotriacetic acid and the like is used.

7. A method according to any one of claims 1 to 6, **characterized in that** the purifying treatment and/or the treatment with a complexing composition is performed in a spraying method.

8. A method according to any one of claims 1 to 7, **characterized in that** the purifying treatment and the treatment with a complexing composition is performed at a temperature below 50°C, in particular below 40°C, and for a period of at least 1 s, in particular at least 10 s.

9. A method according to any one of claims 1 to 8, **characterized in that** a protective layer is applied on the conductors after having carried out the purifying treatment and treatment with at least one complexing composition.

10. A method according to claim 9, **characterized in that** an organic preservative, in particular an organic copper surface preservative, is applied as a protective layer to preserve the solderability.

11. A method according to any one of claims 1 to 10, **characterized in that** the further treatment is carried out after a period of at most 48 hours, in particular at most 10 hours, following the implementation of the purifying treatment and/or the treatment with at least one complexing composition and/or the application of a protective layer.

## Revendications

1. Procédé pour améliorer la résistance à la corrosion d'un composant électronique, en particulier des tracés conducteurs d'un circuit imprimé, dans lequel, après avoir formé des tracés conducteurs en cuivre, ceux-ci sont soumis à un prétraitement dans lequel des ions ou impuretés ioniques se trouvant à la surface des tracés conducteurs sont éliminé(e)s par un traitement de nettoyage, **caractérisé en ce que** les tracés conducteurs sont traités avec au moins une composition complexifiante après le traitement de nettoyage.

2. Procédé selon la revendication 1, **caractérisé en ce que** le traitement de nettoyage est réalisé avec au moins une composition réductrice ou décapante.

3. Procédé selon la revendication 1 ou 2, **caractérisé en ce que** l'acide sulfurique est mis en oeuvre pour le traitement de nettoyage.

4. Procédé selon la revendication 3, **caractérisé en ce que** l'on met en oeuvre pour le traitement de nettoyage un mélange constitué d'acide sulfurique et d'un agent réducteur additionnel, choisi dans le groupe constitué par le peroxyde d'hydrogène, l'acide formique, l'acide nitrique, l'acide phénolsulfonique ou similaire.

5. Procédé selon l'une des revendications 1 à 4, **caractérisé en ce que** l'on utilise de l'ammoniac comme composition complexifiante.

6. Procédé selon l'une des revendications 1 à 4, **caractérisé en ce que** l'on utilise au moins une composition complexifiante organique, comme par exemple l'EDTA, l'hydrogénotartrate de potassium, l'éthylène diamine, l'acide nitriloacétique et similaire.

7. Procédé selon l'une des revendications 1 à 6, **caractérisé en ce que** le traitement de nettoyage et/ou le traitement avec une composition complexifiante est réalisé dans un procédé de pulvérisation.

8. Procédé selon l'une des revendications 1 à 7, **caractérisé en ce que** le traitement de nettoyage et/ou le traitement avec une composition complexifiante est réalisé à des températures inférieures à 50°C, en particulier inférieures à 40°C et pendant une durée d'au moins 1 s, en particulier d'au moins 10 s.

9. Procédé selon l'une des revendications 1 à 8, **caractérisé en ce que**, après la réalisation du traitement de nettoyage et du traitement avec au moins une composition complexifiante, une couche protectrice est déposée sur les tracés conducteurs.

10. Procédé selon la revendication 9, **caractérisé en ce qu'**un conservateur organique, en particulier un conservateur organique des surfaces en cuivre, est déposé pour conserver la possibilité d'un brasage.

11. Procédé selon l'une des revendications 1 à 10, **caractérisé en ce que** le traitement supplémentaire est réalisé après un laps de temps d'au maximum 48 heures, en particulier d'au maximum 10 heures après la réalisation du traitement de nettoyage et/ou du traitement avec au moins une composition complexifiante et/ou le dépôt de la couche protectrice.
